# EUROPEAN PATENT APPLICATION

(11) **EP 4 456 681 A1**
(43) Date of publication of application: **30.10.2024**
(21) Application number: 22911685.0
(22) Date of filing: 05.12.2022
(51) Int. Cl.: H05K 3/46, H05K 3/06, H05K 1/03

(54) **METHOD FOR MANUFACTURING CIRCUIT BOARD**

(30) Priority: 24.12.2021 KR 20210186739
(71) Applicant: LX Semicon Co., Ltd., Daejeon 34027 (KR)
(72) Inventor: CHO, Nam Tae, Daejeon 34027 (KR); LEE, Jun Ho, Daejeon 34027 (KR)
(74) Representative: Goddar, Heinz J.
(86) International application number: PCT/KR2022/019573
(87) International publication number: WO 2023/121052

(57) **Abstract**

Present embodiment relates to a method for manufacturing a circuit board, and more specifically, to a technique for solving problems that may arise due to etching by injecting epoxy or silicon or inserting a metal block into a gap formed between two or more ceramic substrates.

## Description

### [Technical field]

Present embodiment relates to a method for manufacturing a circuit board.

### [Background Art]

Generally, a circuit board refers to a substrate on which wiring for connecting electrical or electronic components is arranged.

A circuit board may be manufactured by bonding a metal sheet, such as a copper sheet, to opposing surfaces of a ceramic substrate such as alumina (Al₂O₃), aluminum nitride (AlN), or silicon nitride (Si₃N₄).

The bonding methods for circuit boards using ceramic substrates may be broadly divided into three types: the active metal brazing method (AMB) that bonds using a bonding agent made of active metal, the direct bonding method that bonds using the oxide film of the ceramic substrate, and the diffusion bonding method that uses the deposition and diffusion reaction of metal.

The diffusion bonding method may form a thin deposition layer of several hundred nanometers by solid-state reaction, so it has the advantage of being able to manufacture printed circuit boards with excellent thermal shock characteristics because it uses an extremely small amount of metal compared to the active metal method and has excellent bonding strength.

### [Disclosure]

### [Technical Problem]

In this background art, one object of the present embodiment is to provide a method for manufacturing a circuit board that may reduce production costs while solving problems that may occur during the etching process of a metal sheet.

### [Technical solution]

In order to achieve the above-mentioned object, one embodiment provides a method for manufacturing a circuit board, including the steps of: placing two or more ceramic substrates so that they are positioned side by side in a plane; arranging the two or more ceramic substrates within surfaces where an upper metal sheet and a lower metal sheet face each other; injecting epoxy or silicone into a gap between the two or more ceramic substrates; bonding the upper metal sheet and the two or more ceramic substrates, and the lower metal sheet and the two or more ceramic substrates; and etching the upper metal sheet and the lower metal sheet.

In order to achieve the above-mentioned object, another embodiment provides the steps of: placing two or more ceramic substrates so that they are positioned side by side in a plane; arranging the two or more ceramic substrates within surfaces where an upper metal sheet and a lower metal sheet face each other; inserting a metal block into a gap formed between the two or more ceramic substrates; bonding the upper metal sheet and the two or more ceramic substrates, and the lower metal sheet and the two or more ceramic substrates; The present invention provides a method for manufacturing a circuit board, including a step of etching the upper metal sheet and the lower metal sheet.

### [Advantageous Effects]

As described above, according to the present embodiment, a printed circuit board having excellent bonding strength between a ceramic substrate and a metal sheet may be manufactured, the manufacturing cost thereof can be reduced, and there is an effect of solving a problem that may occur during the etching process of the metal sheet.

### [Description of Drawings]

FIG. 1 is a drawing for explaining the arrangement relationship of the metal sheet and the ceramic substrate according to the present embodiment.
FIG. 2 is a drawing for explaining silicon or epoxy injection in the circuit board manufacturing method according to the present embodiment.
FIG. 3 is a drawing for explaining metal block insertion in the circuit board manufacturing method according to the present embodiment.
FIG. 4 is a cross-sectional view of the ceramic substrate, deposition layer, and metal sheet according to the circuit board manufacturing method according to the present embodiment.
FIG. 5 is a drawing for explaining the bonding layer formed according to the circuit board manufacturing method according to the present embodiment.
FIG. 6 is an image of a cross-section of the ceramic substrate and deposition layer formed according to the present embodiment, taken with a scanning electron microscope (SEM).
FIG. 7 is an image of a cross-section of the ceramic substrate, bonding layer, and metal sheet formed according to the present embodiment, taken with a scanning electron microscope (SEM).

### [Mode for Invention]

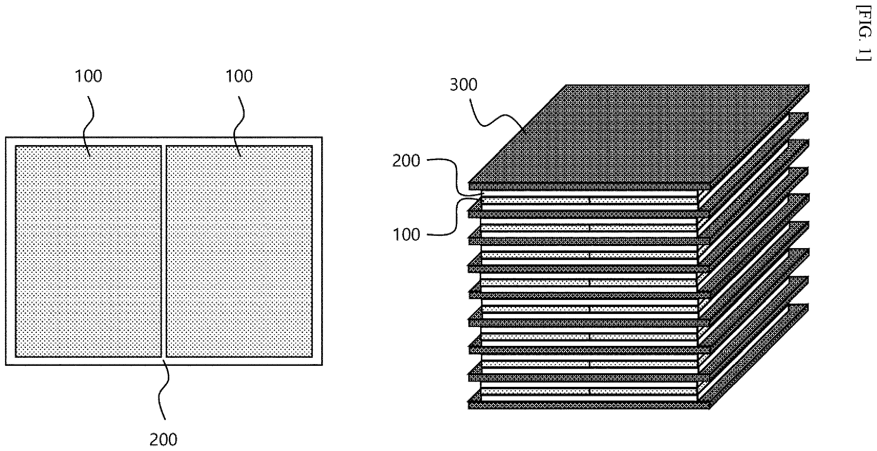

FIG. 1 is a drawing for explaining the arrangement relationship of the metal sheet and the ceramic substrate according to the present embodiment.

The circuit board manufacturing method according to the present embodiment may use a ceramic substrate 100 and a metal sheet 200 and an adhesion prevention sheet 300 may be additionally used to prevent adhesion of the metal sheet 200.

The circuit board manufacturing method according to the present embodiment may perform a step of arranging two or more ceramic substrates so that they are aligned in a plane.

The ceramic substrate 100 may provide heat dissipation performance in the circuit board, and the ceramic substrate 100 may include a component for providing heat dissipation performance. For example, the ceramic substrate 100 may include at least one of Si₃N₄, AlN, or Al₂O₃.

The flexural strength of Si₃N₄ is generally excellent, ranging from 600 to 1,400 MPa, and Si₃N₄ has a low thermal expansion coefficient of about 3.2 x 10⁻⁶/K, so Si₃N₄ may be used at high temperatures. In addition, Si₃N₄ may have a density of about 3.2 g/cm³, a thermal conductivity of about 30 to 178 W/(m K), and a high thermal shock resistance of about 800 to 1,000 K.

The ceramic substrate 100 may be manufactured through a slurry preparation process including ceramic powder, a tape casting process, a punching process, a burnout process, a sintering process, etc.

The slurry preparation process may be a process of preparing a slurry by mixing an organic solvent, a sintering agent, a plasticizer, and a dispersant into the powder. The ceramic powder may include at least one of Si₃N₄ powder, AlN powder, or Al₂O₃ powder. The ceramic powder may be prepared using a ball mill, etc., and the average particle size of the powder may be formed to be 0.8 *µ*m or less. The average particle size may mean the size of the median particle size in a distribution of n particle sizes.

When Si₃N₄ powder is used for the ceramic substrate 100, the Si₃N₄ powder may include at least one of β-Si₃N₄ and α-Si₃N₄. When β-Si₃N₄ and α-Si₃N₄ are mixed and used as the Si₃N₄ powder, the content ratio between the components is not particularly limited.

The type of organic solvent is not particularly limited, but at least one selected from the group consisting of toluene, benzene, xylene, methyl ethyl ketone (MEK), propylene glycol monomethyl ether acetate (PGMEA), propylene glycol monomethyl ether (PGME), ethanol, butanol, or methanol may be used.

The type of sintering aid is also not particularly limited, but rare earth element oxides, alkaline earth metal oxides, and combinations thereof may be used.

The type of plasticizer is also not particularly limited, but at least one selected from the group consisting of di-2-ethylhexyl phthalate, di-n-butyl butyl, butyl phthalyl butyl glycolate, polyethylene glycol, or dioctyl phthalate may be used.

The dispersant is not particularly limited, but at least one selected from the group consisting of a polyester-based dispersant, a polyacrylate-based dispersant, a polyurethane-based dispersant, or a polyether-based dispersant may be used.

The tape casting process may be a process of manufacturing a ceramic tape by applying a slurry to a polymer film at a certain thickness and then passing it through a drying chamber.

The punching process may be a process of manufacturing a ceramic green sheet by pressing and cutting a ceramic tape.

The burnout process may be a process performed by heat treating a ceramic green sheet. Specifically, the degreasing process may be performed by heat treatment in an air or nitrogen atmosphere. Specific heat treatment conditions are not particularly limited, but heat treatment may be performed at a temperature ranging from 400 to 800° C for 6 to 18 hours.

The sintering process may be a process of sintering the ceramic green sheet on which the degreasing process has been performed. Sintering may be performed by gas pressure sintering (GPS). Specific gas pressure sintering conditions are not particularly limited, but a gas pressure sintering furnace with a temperature in the range of 1600 to 2000° C, a nitrogen atmosphere, and 8 to 12 atmospheres (atm) may be used in the sintering process.

After sintering, a ceramic substrate 100 containing one or more of Si₃N₄, AlN, or Al₂O₃ may be manufactured through post-processing including grinding.

The shape of the ceramic substrate 100 may be a rectangular plate shape as shown in FIG. 1, and may also have a polygonal, circular, or oval shape.

The size of the ceramic substrate 100 is not particularly limited, but may be 150 to 220 mm in width and 100 to 160 mm in height. Additionally, the size of the ceramic substrate 100 may be changed horizontally and vertically, and may specifically have a width of 138 mm and a height of 190 mm.

The thickness of the ceramic substrate 100 is not particularly limited, but may be formed from 0.05 to 2.0 mm.

When two or more ceramic substrates 100 are used, the size and shape of each of the two or more ceramic substrates 100 may be the same or different.

When two or more ceramic substrates 100 are used, two or more ceramic substrates 100 may be arranged side by side in a plane, which may mean that the two or more ceramic substrates 100 do not overlap each other or are not stacked.

All lower surfaces of two or more ceramic substrates 100 may be bonded to the lower metal sheet, and all upper surfaces of two or more ceramic substrates 100 may be bonded to the upper metal sheet.

The circuit board manufacturing method according to present embodiment may include arranging the two or more ceramic substrates 100 on surfaces where the upper metal sheet and the lower metal sheet face each other.

Here, the upper metal sheet and lower metal sheet are named according to the location where the metal sheet 200 is placed, so the upper metal sheet and lower metal sheet may be reversed depending on the direction the viewer is looking or the location where the metal sheet 200 is placed.

The area of the metal sheet 200 may be equal to or larger than the area of two or more ceramic substrates 100. Specifically, the area of the metal sheet 200 may be 6.0 times or less, 5.0 times or less, 4.0 times or less, 3.0 times or 2.5 times or less, 1.5 times or more, 1.6 times or more, and 1.7 times the area of the ceramic substrate 100. It may be 1.8 times or more, 1.9 times or more, or 2.0 times or more, and may be 2.4 times or less, 2.3 times or less, 2.2 times or less, or 2.1 times or less.

If the area of the metal sheet 200 is too large, the etchant may not be easily washed away, causing problems such as pooling on the substrate (residue of the etchant) or uneven etching.

According to an example of present embodiment, when one side of the metal sheet 200 has a square shape, the width may be 250 to 300 mm and the length may be 160 to 210 mm. The horizontal and vertical lengths of the metal sheet 200 may be reversed.

The thickness of the metal sheet 200 is not particularly limited, but may be formed in the range of 0.05 to 3.0 mm.

The metal included in the metal sheet 200 is not particularly limited, but may include at least one of Cu, Al, Ni, or Fe.

The circuit board manufacturing method according to present embodiment may include bonding the upper metal sheet and the two or more ceramic substrates, and the lower metal sheet and the two or more ceramic substrates.

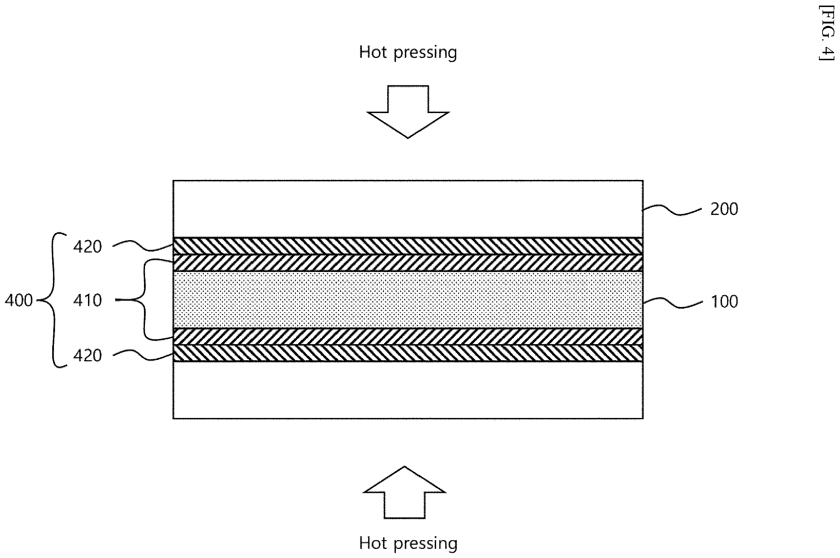

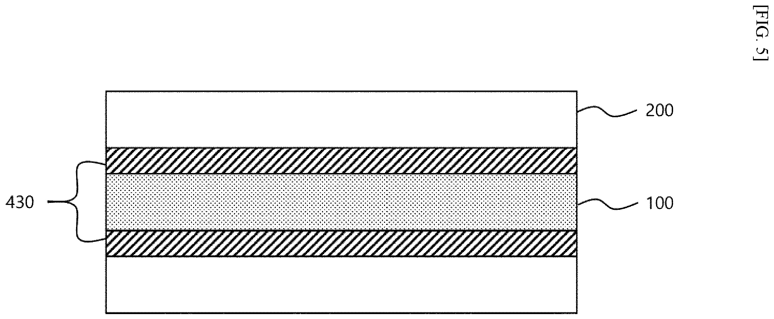

The metal sheet 200 and two or more ceramic substrates 100 may be bonded by forming a deposition layer on the ceramic substrate 100 and hot pressing, or by using a bonding material. This will be explained in detail in the description of FIGS. 4 and 5 described later.

The circuit board manufacturing method according to present embodiment may include etching the upper metal sheet and the lower metal sheet.

The etching of the metal sheet 200 may be performed using an etchant, and there is no particular limitation, but the etchant used for etching the metal sheet 200 may be a known etchant.

In present embodiment, a metal sheet 200 with an area at least 1.5 times larger than the area of the ceramic substrate 100 may be used. In circuit board manufacturing, etching is performed, when there are two or more ceramic substrates subject to a single etching process through an arrangement like present embodiment, the effective area increases and more etched pieces may be produced, and at the same time, the discarded portions are reduced. In addition, since there is an effect of inputting two substrates to be etched into the etching line, rather than inputting one substrate at a time for the etching process, the process time is shortened and related costs (e.g., labor costs, etc.) are reduced.

According to an example of present embodiment, in relation to the arrangement of the metal sheet 200 and the ceramic substrate 100, the two or more ceramic substrates 100 may be arranged on one side of the metal sheet 200 at a predetermined distance from the edge of the metal sheet 200. When spaced from the edge of the metal sheet 200, a place to be clamped by a zig may be secured during the process, and since the distance between two or more ceramic substrates 100 becomes closer, dead zones are reduced and waste of raw materials may be prevented.

A stacking structure having a structure of 'metal sheet/two or more ceramic substrates/metal sheets' according to present embodiment may be referred to as a set of Master Card (MC).

According to one example of present embodiment, a Master Card stack in which Master Cards are stacked may be manufactured, and at this time, an anti-adhesion sheet 300 may be used between each set of master cards to prevent adhesion between metal sheets 200.

The components of the anti-adhesion sheet 300 are not particularly limited, but may include graphite, and the anti-adhesion sheet 300 may be called a carbon plate.

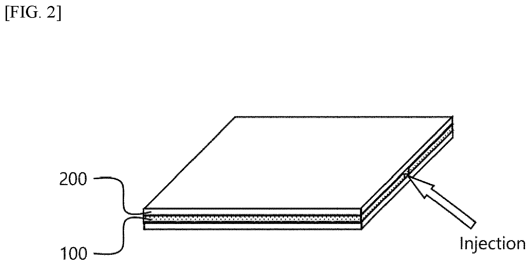

FIG. 2 is a diagram to explain silicone or epoxy injection in the circuit board manufacturing method according to present embodiment.

When two or more ceramic substrates 100 are placed side by side in a plane according to the circuit board manufacturing method according to present embodiment, a gap may be inevitably formed between two or more ceramic substrates 100.

Accordingly, when performing the step of etching the metal sheet 200, the etchant flows into the gap formed between two or more ceramic substrates 100, as a result, problems such as weakening of the bonding force between the metal sheet 200 and the ceramic substrate 100 or corrosion of the back surface of the metal sheet 200 (the surface bonded to the ceramic substrate) may occur.

Therefore, in the circuit board manufacturing method according to present embodiment, a step of injecting epoxy or silicon into the gap formed between two or more ceramic substrates 100 may be performed.

Specifically, two or more ceramic substrates 100 are placed on the surface facing the metal sheet 200, and an epoxy gun or silicon gun is used between the placed ceramic substrates 100. Thus, one or more of epoxy or silicon may be injected into the gap formed between two or more ceramic substrates 100.

Additionally, one or more of epoxy and silicon may be injected into both ends of the gap formed by the upper metal sheet, lower metal sheet, and two or more ceramic substrates 100. Both ends of the gap formed between two or more ceramic substrates 100 refer to the end of the gap located in the cross section of a metal sheet / ceramic substrate / metal sheet stacking structure where the gap formed by two or more ceramic substrates 100 is visible.

Accordingly, the gaps formed between two or more ceramic substrates 100 are filled with one or more of epoxy and silicon to fill the gaps, and during the etching process using an etchant, it is possible to prevent the etchant from flowing into the gap between two or more ceramic substrates 100.

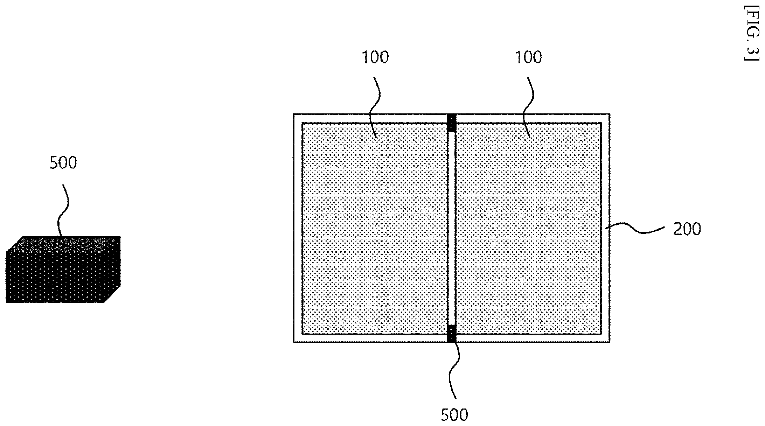

FIG. 3 is a diagram for explaining metal block insertion in the circuit board manufacturing method according to present embodiment.

As mentioned in the description of FIG. 2, when two or more ceramic substrates 100 are placed side by side in a plane according to the circuit board manufacturing method according to present embodiment, a gap may be inevitably formed between two or more ceramic substrates 100.

Accordingly, when performing the step of etching the metal sheet 200, the etchant may flow into the gap formed between two or more ceramic substrates 100, thus problems such as the bonding strength between the metal sheet 200 and the ceramic substrate 100 becoming weak or the back surface of the metal sheet 200 (the surface bonded to the ceramic substrate) being corroded may occur.

Therefore, in the circuit board manufacturing method according to present embodiment, the step of inserting the metal block 500 into the gap formed between two or more ceramic substrates 100 may be performed.

Two or more ceramic substrates 100 are placed on the face of the metal sheet 200, and by placing the metal block 500 between the arranged ceramic substrates 100, the gap formed between two or more ceramic substrates 100 is filled.

Specifically, a metal block 500 may be inserted between two or more ceramic substrates 100, after the metal block 500 is inserted, hot pressure is applied to the outside of the upper metal sheet and lower metal sheet to bond the metal sheet 200 and the ceramic substrate 100, and the metal block 500 may be deformed to fit the shape of the gap and fill the gap so that there is no empty space.

The metal block 500 may be formed of a metal that does not react with the etchant used in the etching process, and although not specifically limited, the metal block 500 may include at least one of Fe, Ti, Ni, Mo, or W.

The metal block 500 may be the same as the thickness of the ceramic substrate 100 or may be formed thicker than the thickness of the ceramic substrate 100.

The metal blocks 500 may be inserted one at a time at both ends of the gap formed by the upper metal sheet, lower metal sheet, and two or more ceramic substrates 100.

Both ends of the gap formed between two or more ceramic substrates 100 refer to the end of the gap located in the cross section of a metal sheet / ceramic substrate / metal sheet stacking structure where the gap formed by two or more ceramic substrates 100 is visible.

FIG. 4 is a cross-sectional view of a ceramic substrate, deposition layer, and metal sheet according to the circuit board manufacturing method according to present embodiment.

According to an example according to present embodiment, a deposition layer 400 may be formed on the upper and lower surfaces of the ceramic substrate 100, respectively, and may be called an upper deposition layer and a lower deposition layer. The deposition layer 400 formed on the ceramic substrate 100 may have an area equal to that of the ceramic substrate 100 or may have an area smaller than the area of the ceramic substrate 100. Specifically, the area of the deposition layer 400 may be 50% or 100% of the area of the ceramic substrate 100.

The material forming the deposition layer 400 is not particularly limited, but may include one or more of Ag and Ti. When one or more of Ag and Ti is used in the deposition layer 400, the deposition amount of Ag per unit area may range from 3.50 to 6.10 g/m², and the deposition amount of Ti per unit area may range from 0.61 to 1.30 g/m². Here, the deposition amount per unit area may mean the content of the deposition component relative to the deposition layer area. The bonding strength of the deposition layer may be controlled by adjusting the components used in the deposition layer and the deposition amount.

According to one example of present embodiment, the deposition amount per unit area of Ti included in the deposition layer 400 may range from 0.61 to 1.30 g/m². In terms of providing stronger adhesion between the metal sheet 200 and the ceramic substrate 100, the deposition amount of Ti per unit area may be in the range of 1.02 to 1.30 g/m², specifically it may be the range of 1.04 to 1.20 g/m².

The deposition amount per unit area of Ag included in the deposition layer 400 may range from 3.50 to 6.10 g/m². In terms of providing stronger bonding force between the metal sheet 200 and the ceramic substrate 100, the deposition amount of Ag per unit area may be in the range of 4.00 to 4.60 g/m².

In addition, the shape of the deposition layer 400 formed on the upper and lower surfaces of the ceramic substrate 100 may be formed in the same shape as the upper and lower surfaces of the ceramic substrate 100, or may be formed in a different shape.

The process by which the deposition layer 400 is formed is not particularly limited, but processes such as sputtering for physical vapor deposition (PVD) or chemical vapor deposition (CVD) may be used.

Through the deposition layer forming process, an upper deposition layer and a lower deposition layer may be formed on the upper and lower surfaces of the ceramic substrate 100, respectively.

The upper deposition layer may be placed to face the upper metal sheet, and the lower deposition layer may be placed to face the lower metal sheet. Additionally, the deposition layer 400 may be a medium for bonding the metal sheet 200 and the ceramic substrate 100 through hot pressing.

When two or more ceramic substrates 100 are used, a deposition layer 400 may be formed on each of the two or more ceramic substrates 100, and two or more ceramic substrates 100 and metal sheets 200 may be bonded by hot pressing.

According to an example according to present embodiment, one or more of the upper deposition layer and the lower deposition layer may include a first deposition layer 410 and a second deposition layer 420 having different components from each other.

Specifically, the first deposition layer 410 may include Ti, and the second deposition layer 420 may include Ag. The first deposition layer 410 may refer to a layer closer to the ceramic substrate 100 than the second deposition layer 420. For example, as shown in FIG. 4, a first deposition layer 410 may be formed on the ceramic substrate 100, and a second deposition layer 420 may be formed on the first deposition layer 410.

With regard to the first deposition layer 410 and the second deposition layer 420, the circuit board manufacturing method according to present embodiment may include forming a first deposition layer 410 containing Ti on the upper and lower surfaces of the ceramic substrate 100, respectively; and forming a second deposition layer 420 containing Ag on the first deposition layer 410.

Accordingly, as shown in FIG. 1, a stacking structure in which the second deposition layer 420, the first deposition layer 410, the ceramic substrate 100, the first deposition layer 410, and the second deposition layer 420 are located sequentially may be manufactured.

The first deposition layer 410 and the second deposition layer 420 may have the same area as the upper and lower surfaces of the ceramic substrate 100, may have a smaller area, may have the same shape or may be formed into different shapes.

The deposition amount per unit area of Ti included in the first deposition layer 410 may range from 0.61 to 1.30 g/m², the deposition amount of Ti per unit area may range from 1.02 to 1.30 g/m², and in terms of providing stronger bonding force between the metal sheet 200 and the ceramic substrate 100, it may be in the range of 1.04 to 1.20 g/m².

The deposition amount per unit area of Ag included in the second deposition layer 420 may range from 3.50 to 6.10 g/m², and in terms of providing stronger adhesion between the metal sheet and the ceramic substrate, the deposition amount of Ag per unit area may be in the range of 4.00 to 4.60 g/m².

By hot pressing the upper and lower metal sheets on which the deposition layer 400 is formed, the ceramic substrate 100 and the upper and lower metal sheets may be bonded.

Hot pressing may be performed by hot pressing the upper and lower metal sheets in the direction of the ceramic substrate 100 at a temperature of 450 to 1,300 °C and a pressure of 1 to 25 MPa. Additionally, hot pressing is not particularly limited, but may be performed, for example, at about 10⁻¹ to 10⁻⁵ torr.

According to present embodiment, the lower limit of the temperature during bonding through hot pressing may be 500 °C or higher, 600 °C or higher, 700 °C or higher, or 800 °C or higher. And, the upper limit may be 1050°C or less, 1000°C or less, 950°C or less, or 900°C or less.

According to present embodiment, the lower limit of the pressure when joining through hot pressing may be 5 Mpa or more or 10 Mpa or more. And, the upper limit may be 20 Mpa or less or 15 Mpa or less.

In the circuit board manufacturing method according to present embodiment, two or more ceramic substrates 100 may be used, and a deposition layer 400 may be formed on two opposing sides of the ceramic substrate 100. Then, the metal sheet 200 may be placed on the deposition layer 400, and the ceramic substrate 100 and the metal sheet 200 may be bonded by applying hot pressing from the outside of the metal sheet 200.

FIG. 5 is a diagram for explaining the bonding layer formed according to the circuit board manufacturing method according to present embodiment.

Through hot pressing, the upper and lower metal sheets 200 and the ceramic substrate 100 may be bonded via the deposition layer 400, as shown in FIG. 5, the bonding layer 430 may be formed on the ceramic substrate 100, and a metal sheet 200 may be placed on the bonding layer 430. Here, the bonding layer 430 may refer to a layer that may be created by passing the deposition layer 400 or other bonding materials through a bonding step.

When explaining present embodiment using FIGs 4 and 5,

Due to hot pressing, diffusion between materials included in each of the ceramic substrate 100, deposition layer 400, and metal sheet 200 may occur.

For example, when Ti is included in the first deposition layer 410 and Si₃N₄ is included in the ceramic substrate 100, a reaction as shown in Reaction Formula 1 below may occur between Ti and Si₃N₄.

[Reaction Formula 1] 4Ti+Si₃N₄ →3Si+4TiN

That is, by hot pressing, the material contained in the deposition layer 400 and the material contained in the ceramic substrate 100 may react to form the bonding layer 430, and the bonding layer 430 may include TiN.

The bonding layer 430 according to present embodiment is a layer containing TiN and may act as a strong bonding media layer between the ceramic substrate 100 and the metal sheet 200. That is, by forming the bonding layer 430 through the diffusion bonding method, bonding of the ceramic substrate 100 and the metal sheet 200 may be achieved.

When bonding between layers containing different materials occurs, stress is transferred to the layer containing materials with relatively weak strength, and desorption between layers may easily occur. Therefore, increasing the strength of a layer containing a relatively weak material may be more effective in improving the bonding strength in bonding between layers containing different materials.

For example, Ag included in the second deposition layer 420 may diffuse toward the metal sheet 200 containing Cu during hot pressing and compensate for the weak strength of the metal sheet 200 at the interface. By the same principle as above, Ag included in the second deposition layer 220 may improve the adhesion between the ceramic substrate 100 and the metal sheet 200. In addition, Ag included in the second deposition layer 420 may help promote the formation of a reaction layer with Ti included in the first deposition layer 410 and Cu included in the metal sheet 200 by improving wettability by forming a liquid phase composed of a Cu-Ti-Ag ternary system.

If the deposition amount per unit area of Ag included in the second deposition layer 420 is less than the numerical range according to present embodiment, since the strength of the metal sheet 200 cannot be sufficiently increased, the adhesion between the ceramic substrate 100 and the metal sheet 200 is poor. In addition, when the deposition amount per unit area of Ag included in the second deposition layer 420 exceeds the numerical range according to present embodiment, since more Ag than necessary is deposited to form Ag residue that does not diffuse, there is a problem in that the bonding force between the ceramic substrate 100 and the metal sheet 200 is reduced.

The circuit board manufacturing method according to present embodiment may manufacture a board with excellent bonding strength between each layer. Accordingly, the circuit board according to present embodiment, the occurrence of delamination may be greatly suppressed even when exposed to repeated thermal shock environments.

After the bonding step, the circuit board may be manufactured through a resist printing process, an etching process, a plating process, etc., on the bonded ceramic substrate 100 and/or metal sheet 200.

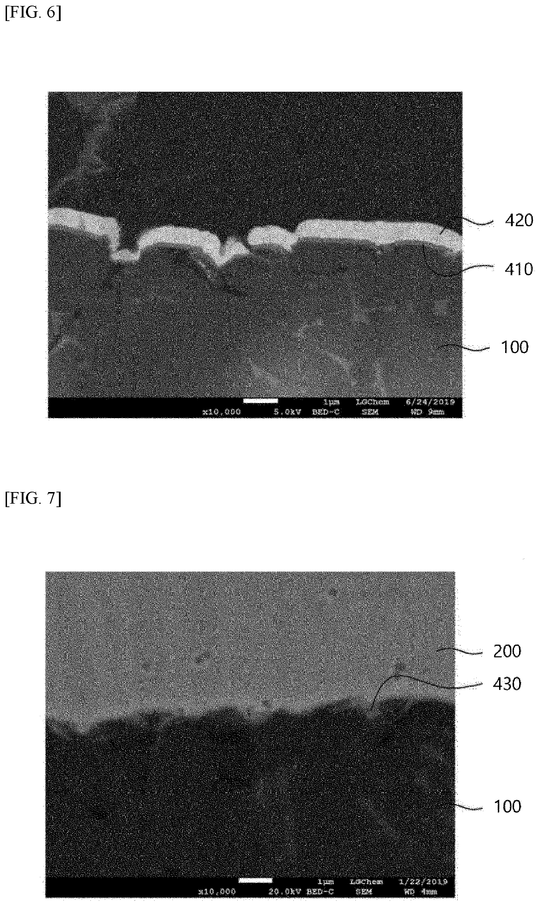

FIG. 6 is an image taken with a scanning electron microscope (SEM) of the cross section of the ceramic substrate and deposition layer formed according to present embodiment.

That is, FIG. 6 is a cross-sectional image after the deposition step and before the bonding step. Through this, it may be confirmed that the first deposition layer 410 containing Ti and the second deposition layer 420 containing Ag were formed on the ceramic substrate 100.

FIG. 7 is an image taken with a scanning electron microscope (SEM) of the cross section of the ceramic substrate, bonding layer, and metal sheet formed according to present embodiment.

That is, FIG. 7 is a cross-sectional image after the joining step. Through this, it may be confirmed that the bonding layer 430 is formed after the bonding step through the diffusion bonding method, and the ceramic substrate 100 and the metal sheet 200 are bonded.

The operation and effects of the invention will be described in more detail through specific examples below. However, this is presented as an example of the invention, and the scope of the invention is not limited by this in any way.

### Manufacturing example (manufacturing of ceramic substrate)

A Si₃N₄ powder with an average particle diameter of 0.8 *µ*m or less is manufactured through a ball mill. Organic solvent (e.g. toluene, methanol, ethanol), Sintering aids (e.g. Y₂O₃, MgO), Plasticizers (e.g. Dioctyl Phthalate (DOP), Polyethylene glycol (PEG)) and a dispersant (e.g. BYK-111) is added into Si₃N₄ powder to prepare a slurry and then passed through a drying chamber to produce a Si₃N₄ tape. A Si₃N₄ green sheet was manufactured by pressing and cutting the Si₃N₄ tape, and a degreasing process was performed by heat treatment at 600 °C for 12 hours. Afterwards, a ceramic substrate (silicon nitride Si₃N₄ substrate) of a predetermined size (Width 190 mm x Height 138 mm x Thickness 0.32 mm) was manufactured by sintering at 1850 °C and 1 MPa under a nitrogen atmosphere using a gas pressure sintering method.

### Experiment 1: Confirmation of production cost reduction

Ti (first deposition layer) and Ag (second deposition layer) were sequentially deposited on the opposing upper and lower surfaces of the ceramic substrate in the manufacturing example. At this time, about 1.0 g/m² of Ti was deposited, and about 6.08 g/m² of Ag was deposited. Two ceramic substrates were prepared as described above and deposited on both the upper and lower surfaces where the first and second deposition layers face each other.

In addition, two copper sheets (Cu sheets) measuring 270 mm x 190 mm x 0.3 mm were prepared.

Place one of the above copper sheets, then place two ceramic substrates on one side of the copper sheet by placing them adjacent to each other to minimize gaps between the two ceramic substrates (At this time, two or more ceramic substrates are positioned side by side on a copper sheet, and the deposition layer (Ag deposition layer) of each ceramic substrate is positioned in contact with the copper sheet), and the remaining copper sheet was placed on top thereof in the same manner to manufacture a non-bonded stacking structure in the form of a copper sheet/two ceramic substrates (located side by side in a plane)/copper sheets. At this time, the overlap area between the two ceramic substrates and the copper sheet was set to about 90%.

Afterwards, the stacking structure was treated with hot press equipment while being pressed at 15 MPa in an atmosphere of about 10⁻⁴ torr and a temperature of 980°C. As a result, a sample of a copper sheet with a copper sheet and a silicon nitride substrate bonded to each other/two ceramic substrates (located side by side in a plane)/copper sheet was obtained.

Copper was etched using the sample to manufacture a copper circuit. Specifically, after attaching a dry film to both outer sides of the stacking structure, UV is irradiated on the film to leave a part where the copper should not be etched (circuit part), and the film in the remaining part other than the circuit part is peeled off. This was put into an etching line and copper was etched.

As a result, compared to etching two comparison samples (copper sheet/ceramic substrate/copper sheet) with one ceramic substrate bonded to each other, etching a sample (copper sheet/two ceramic substrates (located side by side)/copper sheet) manufactured as in the present invention may reduce the time required to make the same number of circuits by almost half, and during the same etching process time, more circuit board pieces may be produced (e.g., increased production by approximately 30% or more). In this way, according to present invention, the cost reduction effect is significant.

### Experiment 2: Joint strength evaluation

In accordance with ASTM D6682, the bonding force (N/mm) was measured for the specimens of Embodiments 1 to 6 and Comparative Examples 1 to 6 below. Specifically, a sample of a copper sheet/silicon nitride substrate/copper sheet structure in which a copper sheet and a silicon nitride substrate were bonded to each other was etched, and a sample in which a copper strip with a width of 5 mm and a length of 100 mm was bonded to a ceramic substrate was prepared. Before testing, approximately 10 mm of the end of the Cu strip was manually separated so that the Cu strip could be held by the grip of the universal testing machine (equipment company and model name: Ametek, LS5). The specimen was fixed to the universal testing machine, the Cu strip was held with a grip, separated at a speed of 50 mm/min, and the stress was measured to calculate the joint strength.

The results are shown in Tables 1 to 3 below.

### Embodiment 1 (Ti deposition amount 1.076 g/m², Ag deposition amount 4.005 g/m²)

On the ceramic substrate in the manufacturing example, 0.0282 g of Ti was deposited for 70 seconds through a sputtering method to form a first deposition layer. Then, 0.105 g of Ag was deposited on the first layer for 30 seconds to form a second deposition layer. At this time, the formation area of the first deposition layer and the second deposition layer was adjusted to be the same as that of the ceramic substrate (width 190 mm x height 138 mm). Here, the deposition amount of Ti per unit area is 1.076 g/m², and the deposition amount of Ag per unit area is 4.005 g/m².

Then, two ceramic substrates manufactured as above and two copper sheets (width 270 mm x height 185 mm x thickness 0.3 mm) were prepared. Place two ceramic substrates adjacent to each other to minimize gaps between each other, and place two ceramic substrates on one side of one prepared copper sheet (At this time, the two ceramic substrates are positioned side by side on a copper sheet, and the deposition layer [second deposition layer containing Ag] of each ceramic substrate is positioned in contact with the copper sheet), then the remaining copper sheet was placed on top thereof in the same manner to manufacture a non-bonded stacking structure in the form of a copper sheet/two ceramic substrates (located side by side in a plane)/copper sheets. At this time, the overlap area between the two ceramic substrates and the copper sheet was set to about 95%.

Afterwards, the stacking structure was hot-pressed at a temperature of 980 °C and a pressure of 15 MPa in an atmosphere of approximately 10⁻⁴ torr.

Through the above series of processes, a specimen containing a Cu metal sheet, a TiN bonding layer, and Si₃N₄ was manufactured.

### Embodiment 2 (Ti deposition amount 1.194 g/m², Ag deposition amount 4.005 g/m²)

A specimen containing a Cu metal sheet, a TiN bonding layer, and a Si₃N₄ ceramic substrate was manufactured in the same manner as Embodiment 1, except that 0.0313 g of Ti was deposited to form the first layer. At this time, the deposition amount of Ti per unit area is 1.194 g/m², and the deposition amount of Ag per unit area is 4.005 g/m².

### Embodiment 3 (Ti deposition amount 1.030 g/m², Ag deposition amount 5.339 g/m²)

A specimen containing a Cu metal sheet, a TiN bonding layer, and a Si₃N₄ ceramic substrate was manufactured in the same manner as in Embodiment 1, except that 0.0270 g of Ti was deposited to form the first layer, and 0.1400 g of Ag was deposited to form the second layer, and a specimen containing a ceramic substrate of Si₃N₄ was manufactured. At this time, the deposition amount of Ti per unit area is 1.030 g/m², and the deposition amount of Ag per unit area is 5.339 g/m².

### Embodiment 4 (Ti deposition amount 1.220 g/m², Ag deposition amount 5.339 g/m²)

A specimen containing a Cu metal sheet, a TiN bonding layer, and a Si₃N₄ ceramic substrate was manufactured in the same manner as in Embodiment 1, except that 0.0320 g of Ti was deposited to form the first layer, and 0.1400 g of Ag was deposited to form the second layer. At this time, the deposition amount of Ti per unit area is 1.220 g/m², and the deposition amount of Ag per unit area is 5.339 g/m².

### Embodiment 5 (Ti deposition amount 1.003 g/m², Ag deposition amount 4.005 g/m²)

A specimen containing a Cu metal sheet, a TiN bonding layer, and a Si₃N₄ ceramic substrate was manufactured in the same manner as in Embodiment 1, except that 0.0263 g of Ti was deposited to form the first layer. At this time, the deposition amount of Ti per unit area is 1.003 g/m², and the deposition amount of Ag per unit area is 4.005 g/m².

### Embodiment 6 (Ti deposition amount 0.961 g/m², Ag deposition amount 4.005 g/m²)

A specimen containing a Cu metal sheet, a TiN bonding layer, and a Si₃N₄ ceramic substrate was manufactured in the same manner as Embodiment 1, except that 0.0252 g of Ti was deposited to form the first layer. At this time, the deposition amount of Ti per unit area is 0.961 g/m², and the deposition amount of Ag per unit area is 4.005 g/m².

### Comparative Example 1 (Ti deposition amount 0.374 g/m², Ag deposition amount 2.868 g/m²)

A specimen containing a Cu metal sheet, a TiN bonding layer, and a Si₃N₄ ceramic substrate was manufactured in the same manner as in Embodiment 1, except that 0.0098 g of Ti was deposited to form the first layer, and 0.0752 g of Ag was deposited to form the second layer. At this time, the deposition amount of Ti per unit area is 0.374 g/m², and the deposition amount of Ag per unit area is 2.868 g/m².

### Comparative Example 2 (Ti deposition amount 0.599 g/m², Ag deposition amount 2.868 g/m²)

A specimen containing a Cu metal sheet, a TiN bonding layer, and a Si₃N₄ ceramic substrate was manufactured in the same manner as in Embodiment 1, except that 0.0157 g of Ti was deposited to form the first layer, and 0.0752 g of Ag was deposited to form the second layer. At this time, the deposition amount of Ti per unit area is 0.599 g/m², and the deposition amount of Ag per unit area is 2.868 g/m².

### Comparative Example 3 (Ti deposition amount 0.843 g/m², Ag deposition amount 2.868 g/m²)

A specimen containing a Cu metal sheet, a TiN bonding layer, and a Si₃N₄ ceramic substrate was manufactured in the same manner as in Embodiment 1, except that 0.0221 g of Ti was deposited to form the first layer, and 0.0752 g of Ag was deposited to form the second layer. At this time, the deposition amount of Ti per unit area is 0.843 g/m², and the deposition amount of Ag per unit area is 2.868 g/m².

### Comparative Example 4 (Ti deposition amount 1.034 g/m², Ag deposition amount 2.868 g/m²)

A specimen containing a Cu metal sheet, a TiN bonding layer, and a Si₃N₄ ceramic substrate was manufactured in the same manner as in Embodiment 1, except that 0.0342 g of Ti was deposited to form the first layer, and 0.0752 g of Ag was deposited to form the second layer. At this time, the deposition amount of Ti per unit area is 1.304 g/m², and the deposition amount of Ag per unit area is 2.868 g/m².

### Comparative Example 5 (Ti deposition amount 1.041 g/m², Ag deposition amount 6.808 g/m²)

A specimen containing a Cu metal sheet, a TiN bonding layer, and a Si₃N₄ ceramic substrate was manufactured in the same manner as in Embodiment 1, except that 0.0273 g of Ti was deposited to form the first layer, and 0.1785 g of Ag was deposited to form the second layer. At this time, the deposition amount of Ti per unit area is 1.041 g/m², and the deposition amount of Ag per unit area is 6.808 g/m².

### Comparative Example 6 (Ti deposition amount 0.599 g/m², Ag deposition amount 4.005 g/m²)

A specimen containing a Cu metal sheet, a TiN bonding layer, and a Si₃N₄ ceramic substrate was manufactured in the same manner as in Embodiment 1, except that 0.0157 g of Ti was deposited to form the first layer. At this time, the deposition amount of Ti per unit area is 0.599 g/m², and the deposition amount of Ag per unit area is 4.005 g/m².

**[Table 1]**

| | Embodiment 1 | Embodiment 2 | Embodiment 3 | Embodiment 4 |
|---|---|---|---|---|
| Ti deposition amount (g) | 0.0282 | 0.0313 | 0.0270 | 0.0320 |
| Ag deposition amount (g) | 0.105 | 0.105 | 0.1400 | 0.1400 |
| Deposition amount of Ti per unit area (g/m²) | 1.076 | 1.194 | 1.030 | 1.220 |
| Deposition amount of Ag per unit area (g/m²) | 4.005 | 4.005 | 5.339 | 5.339 |
| Bonding force (N/mm) | 21.4 | 22.1 | 16.3 | 20.3 |

**[Table 2]**

| | Comparati ve Example 1 | Comparati ve Example 2 | Comparati ve Example 3 | Comparati ve Example 4 | Comparati ve Example 5 |
|---|---|---|---|---|---|
| Ti deposition amount (g) | 0.0098 | 0.0157 | 0.0221 | 0.0342 | 0.0273 |
| Ag deposition amount (g) | 0.0752 | 0.0752 | 0.0752 | 0.0752 | 0.1785 |
| Deposition amount of Ti per unit area (g/m²) | 0.374 | 0.599 | 0.843 | 1.304 | 1.041 |
| Deposition amount of Ag per unit area (g/m²) | 2.868 | 2.868 | 2.868 | 2.868 | 6.808 |
| Bonding force (N/mm) | 0.6 | 3.7 | 4.8 | 7.5 | 15.6 |

**[Table 3]**

| | Embodiment 5 | Embodiment 6 | Comparative Example 6 |
|---|---|---|---|
| Ti deposition amount (g) | 0.0263 | 0.0252 | 0.0157 |
| Ag deposition amount (g) | 0.105 | 0.105 | 0.105 |
| Deposition amount of Ti per unit area (g/m²) | 1.003 | 0.961 | 0.599 |
| Deposition amount of Ag per unit area (g/m²) | 4.005 | 4.005 | 4.005 |
| Bonding force (N/mm) | 9.6 | 9.4 | 8.6 |

First, comparing the specimens of Embodiments 1 and 2 and Comparative Examples 1 to 4, the specimens of Embodiments 1 and 2, in which the Ag deposition amount per unit area was 3.50 g/m² or more, showed excellent bonding strength of 21.4 N/mm and 22.1 N/mm, respectively, on the other hand, the specimens of Comparative Examples 1 to 4 in which the deposition amount of Ag per unit area was less than 3.50 g/m², all showed low bonding strength of 7.5 N/mm or less. In particular, although the deposition amount of Ti per unit area of the specimen of Comparative Example 4 was higher than that of the specimens of Embodiments 1 and 2, the specimen of Comparative Example 4 showed much lower bonding strength due to the small Ag content. This is thought to be the result of a change (improvement) in the strength of the metal sheet depending on the amount of Ag deposited. Next, comparing the specimens of Embodiments 1 and 3 and Comparative Example 5, there is no significant difference in the amount of Ti deposited per unit area. However, the specimens of Embodiments 1 and 3, in which the deposition amount of Ag per unit area was 6.10 g/m² or less, showed excellent bonding strength of 21.4 N/mm and 16.3 N/mm, respectively, on the other hand, the adhesive strength of the specimen of Comparative Example 5 decreased to 15.6 N/mm. This is believed to be the result of Ag residue being formed at the interface due to excessive Ag deposition. Next, comparing the specimens of Embodiments 1, 2, 5, 6 and Comparative Example 6, the deposition amount of Ag per unit area is almost the same. The specimens of Embodiments 1, 2, 5, and 6 with a Ti deposition amount per unit area of 0.61 g/m² or more showed bonding strength of at least 9.4 N/mm, while the specimens of Comparative Example 6 with a Ti deposition amount per unit area of less than 0.61 g/m² showed a low bonding force of less than 8.6 N/mm. This is thought to be the result of the strength of the bonding layer changing (improved) depending on the amount of Ti deposited. In particular, the specimens of Embodiments 1 and 2, in which the deposition amount of Ti per unit area was 1.02 g/m² or more, showed excellent bonding strength of 21.4 N/mm and 22.1 N/mm, respectively.

Next, looking at the specimens of Embodiments 1, 2, and 4, the specimens of Embodiments 1, 2, and 4 in which the deposition amount of Ti per unit area was 1.30 g/m² or less, all showed excellent bonding strength of 20 N/mm or more. However, if the deposition amount of Ti per unit area is 1.02 g/m² or more, even if the deposition amount of Ti increases, the improvement in bonding strength is insufficient and may reach a saturation value. Accordingly, in order to prevent waste of raw materials and at the same time achieve optimal interfacial bonding strength, it is desirable that the deposition amount of Ti per unit area is 1.30 g/m2 or less.

## Claims

1. A method for manufacturing a circuit board comprising:
a step of placing two or more ceramic substrates side by side in a plane;
a step of arranging the two or more ceramic substrates within surfaces where an upper meal sheet and a lower metal sheet face each other;
a step of injecting epoxy or silicone into a gap between the two or more ceramic substrates;
a step of bonding the upper metal sheet and the two or more ceramic substrates, and the lower metal sheet and the two or more ceramic substrates; and
a step of etching the upper metal sheet and the lower metal sheet.

2. The method for manufacturing the circuit board according to claim 1, wherein each of the two or more ceramic substrates each has an upper deposition layer and a lower deposition layer.

3. The method for manufacturing the circuit board according to claim 2, wherein the upper deposition layer and the lower deposition layer comprise Ag and Ti.

4. The method for manufacturing the circuit board according to claim 2, wherein a bonding layer is formed by reacting a material of the deposition layer and a material of the ceramic substrate by hot pressing, and
the bonding layer comprises at least TiN.

5. The method for manufacturing the circuit board according to claim 3, wherein the deposition amount per unit area of the Ag is in a range of 3.50 to 6.10 g/m², and
the deposition amount per unit area of the Ti is in a range of 0.61 to 1.30 g/m².

6. The method for manufacturing the circuit board according to claim 1, wherein areas of the upper metal sheet and the lower metal sheet are formed to be equal to or larger than the two or more ceramic substrates.

7. The method for manufacturing the circuit board according to claim 1, wherein the bonding is performed by hot pressing the upper metal sheet and the lower metal sheet.

8. The method for manufacturing the circuit board according to claim 1, wherein the ceramic substrate comprises at least one of Si₃N₄, AlN or Al₂O₃.

9. The method for manufacturing the circuit board according to claim 1, wherein the upper metal sheet and the lower metal sheet comprise at least one of Cu, Al, Ni or Fe.

10. The method for manufacturing the circuit board according to claim 1, wherein the epoxy or silicone is injected into both ends of the gap formed by the upper metal sheet, the lower metal sheet, and the two or more ceramic substrates.

11. A method for manufacturing a circuit board, comprising:
a step of placing two or more ceramic substrates side by side in a plane;
a step of arranging the two or more ceramic substrates within surfaces where the upper metal sheet and the lower metal sheet face each other;
a step of inserting a metal block into a gap between the two or more ceramic substrates;
a step of bonding the upper metal sheet and the two or more ceramic substrates, and the lower metal sheet and the two or more ceramic substrates; and
a step of etching the upper metal sheet and the lower metal sheet.

12. The method for manufacturing the circuit board according to claim 11, wherein the metal block is a metal that does not react with an etchant used for the etching.

13. The method for manufacturing the circuit board according to claim 11, wherein the metal block comprises at least one of Fe, Ti, Ni, Mo or W.

14. The method for manufacturing the circuit board according to claim 11, wherein a thickness of the metal block is formed to be equal to or thicker than a thickness of the two or more ceramic substrates.

15. The method for manufacturing the circuit board according to claim 11, wherein the metal blocks are inserted one at each end of the gap formed by the upper metal sheet, the lower metal sheet and the two or more ceramic substrates.
